# EUROPEAN PATENT SPECIFICATION

(11) **EP 4 585 897 B1**
(45) Date of publication and mention of the grant of the patent: **11.11.2026**
(21) Application number: 25151056.6
(22) Date of filing: 09.01.2025
(51) Int. Cl.: G01M 17/007

(54) **ROADWAY SIMULATOR WITH LIMITED ENERGIZED OPERATING STATE**
FAHRBAHNSIMULATOR MIT BEGRENZTEM STROMGETRIEBENEM BETRIEBSZUSTAND
SIMULATEUR DE ROUTE AVEC ÉTAT DE FONCTIONNEMENT LIMITÉ SOUS TENSION

(30) Priority: 10.01.2024 US 202463619627 P; 07.01.2025 US 202519012487
(43) Date of publication of application: 16.07.2025
(73) Proprietor: Illinois Tool Works Inc., Glenview IL 60025 (US)
(72) Inventor: SENFT, Victor, Glenview, 60025 (US); MELCHER, David James, Glenview, 60025 (US); SUNDERMAN, Marlin Jay, Glenview, 60025 (US); ZIEMAN, Rick Lee, Glenview, 60025 (US); STAUP, Scott Loren, Glenview, 60025 (US)
(74) Representative: HGF

(56) References cited:
- US-A- 5 402 674
- US-A1- 2009 217 746

## Description

### CROSS-REFERENCE TO RELATED APPLICATION

The present application is based on and claims the benefit of U.S. provisional patent application Serial No. 63/619,627, filed January 10, 2024.

### BACKGROUND

The discussion below is merely provided for general background information and is not intended to be used as an aid in determining the scope of the claimed subject matter.

Aspects of the present invention relate to equipment and methods used during laboratory testing of bodies moving over surfaces such as but not limited to all types of vehicles traveling on a roadway.

Referring to vehicles such as automobiles by way of example, the use of simulated roadways has become important in the development of vehicle designs. These roadway simulators generally comprise one or more individual endless belts that are mounted below the vehicle, engaging one or more wheels, and/or positioned below other body panels of the vehicle. The belts are driven to simulate driving the vehicle over a road. Some roadway simulators are disposed in wind tunnels so as to measure aerodynamic characteristics.

The vehicle is typically restrained with respect to the simulated roadways through one or more restraints that restrains the vehicle from movement in longitudinal direction (fore and aft), in lateral direction (side-to-side) and/or in yaw (steering motion). Commonly, the vehicle restraints are passive restraints which do not affect the vehicle's dynamics, but which can be used for measuring loads if desired in the different directions of restraint.

US5402674A discloses an apparatus and method for automatically restraining a vehicle on a vehicle test stand having at least one pair of rollers rotatably mounted to a frame that comprises a restraining device moveably mounted relative to the test stand frame.

### SUMMARY

This Summary and the Abstract herein are provided to introduce a selection of concepts in a simplified form that are further described below in the Detailed Description.

An aspect of the present invention is a method for testing a vehicle on a roadway simulator according to claim 1 having at least one rotatable assembly for rotating at least one wheel of the vehicle, the method comprising: positioning the vehicle on the at least one rotatable assembly; coupling a restraint to the vehicle so as to limit longitudinal and/or lateral movement of the vehicle on the at least one rotatable assembly, wherein coupling includes controlling a first actuator to position an end of the restraint proximate a portion of the vehicle and controlling a second actuator to couple the restraint to the portion of the vehicle; driving the at least one rotatable assembly to rotate the at least one wheel on the vehicle; configuring the roadway simulator in a lockout state wherein power is isolated from roadway simulator that inhibits operation for conducting a test including isolating electrical power from a rotatable drive assembly for the at least one rotatable assembly and for isolating electrical power from an actuator drive assembly for the first actuator and/or the second actuator; configuring the roadway simulator in a limited energized state wherein testing of the vehicle is inhibited due to continued isolation of electrical power to the rotatable drive assembly and wherein electrical power is restored to the actuator drive assembly for the first actuator and/or the second actuator; and controlling the first actuator to position the end of the restraint remote from the vehicle to allow the vehicle to be removed the at least one rotatable assembly and/or controlling the second actuator to decouple the restraint from the portion of the vehicle.

Implementations may include one or more of the following features. The roadway simulator can include a designated control for configuring the roadway simulator in the limited energized state, and where configuring the roadway simulator in the limited energization state includes providing a control signal from the designated control to energize circuitry for the first and/or second actuator. In one embodiment, the designated control can be remote from a user interface for operating the roadway simulator to perform the test of the vehicle by controlling the at least one rotatable assembly. In another embodiment, the designated control can be part of a user interface for operating the roadway simulator to perform the test of the vehicle by controlling the at least one rotatable assembly. If desired, the designated control is not configured to operate a switch that provides electrical power to the rotatable drive assembly.

Providing the control signal can include providing a control signal to a first controlled switch to operate the first controlled switch to provide electrical power to the actuator drive assembly for the first actuator and/or the second actuator. The actuator drive assembly may include an actuator electrical power supply providing power to the first actuator and/or the second actuator and an actuator control module connected to the actuator electrical power supply and configured to control operation of the actuator electrical power supply.

A power supply switch can selectively provide electrical power to the actuator electrical power supply, and a control module switch selectively provides electrical power to the actuator control module, and where providing the control signal operates the power supply switch to provide electrical power to the actuator electrical power supply, and operates the control module switch to provide electrical power to the actuator control module. The power supply switch can selectively provide electrical power to another portion of the roadway simulator different than the actuator electrical power supply, the another portion of the roadway simulator having another control module different than the actuator control module, where providing the control signal does not provide electrical power to the another control module.

The roadway simulator may include a positioner for controlling a position of an element of the roadway simulator, and where configuring the roadway simulator in the lockout state may include isolating electrical power to a positioner drive assembly of the positioner, and where configuring the roadway simulator in the limited energized state, may include restoring electrical power to the positioner drive assembly. The positioner positions the element in a selected position to allow removal of the vehicle from the roadway simulator.

The roadway simulator may include a turntable supporting the vehicle in selected angular positions, and the positioner drive assembly rotates the turntable. The positioner is coupled to the at least one rotatable assembly. The positioner drive assembly may include a positioner electrical power supply providing power to the positioner and a positioner control module connected to the positioner electrical power supply and configured to control operation of the positioner electrical power supply.

A positioner power supply switch can selectively provide electrical power to the positioner electrical power supply, and a positioner control module switch selectively provides electrical power to the positioner control module, and where providing the control signal operates the positioner power supply switch to provide electrical power to the positioner electrical power supply, and operates the positioner control module switch to provide electrical power to the positioner control module.

Coupling the restraint to the vehicle may include coupling the restraint to a side portion of the vehicle. The first actuator adjusts a position of the end of the restraint, and the second actuator operates a coupler that couples the restraint to the vehicle. Coupling the restraint to the vehicle may include coupling the restraint to an end portion of the vehicle. Coupling the restraint to the vehicle may include coupling the restraint to an upper portion of the vehicle.

The at least one rotatable assembly may include a single belt supporting and rotatably driving each wheel of the vehicle. The at least one rotatable assembly may include a plurality of separate rotatable assemblies, each separate rotatable assembly rotatably driving at least one wheel of the vehicle. The at least one rotatable assembly may include a plurality of separate rotatable assemblies, each separate rotatable assembly rotatably driving one wheel of the vehicle.

Another aspect of the present invention is a roadway simulator according to claim 10 comprising: at least one rotatable assembly for rotating at least one wheel of the vehicle; a restraint couplable to a vehicle so as to limit longitudinal and/or lateral movement of the vehicle on the at least one rotatable assembly, wherein the restraint includes a first actuator to position an end of the restraint proximate a portion of the vehicle and a second actuator to couple the restraint to the portion of the vehicle; a controller operable to configure the roadway simulator in a lockout state wherein power is isolated from roadway simulator that inhibits operation for conducting a test including isolating electrical power from a rotatable drive assembly for the at least one rotatable assembly and for isolating electrical power from an actuator drive assembly for the first actuator and/or the second actuator, and operable to configure the roadway simulator in a limited energized state wherein testing of the vehicle is inhibited due to continued isolation of electrical power to the rotatable drive assembly and wherein electrical power is restored to the actuator drive assembly for the first actuator and/or the second actuator.

Implementations may include one or more of the following features. The roadway simulator may include a designated control for configuring the roadway simulator in the limited energized state, and where the designated control provides a control signal to energize circuitry for the first and/or second actuator. In one embodiment, the designated control can be remote from a user interface for operating the roadway simulator to perform the test of the vehicle by controlling the at least one rotatable assembly. In another embodiment, the designated control is part of a user interface for operating the roadway simulator to perform the test of the vehicle by controlling the at least one rotatable assembly.

### BRIEF DESCRIPTION OF THE DRAWINGS

FIG. 1 is a perspective view of a first embodiment of a vehicle restraint system.
FIG. 2 is an enlarged perspective view of a portion of the first embodiment;
FIG. 3 is a front elevational view of the first embodiment;
FIG. 4 is a perspective view of a second embodiment of a vehicle restraint system.
FIG. 5 is a front elevational view of a portion of the second embodiment;
FIG. 6 is schematic diagram of electrical cabinetry for the simulator; and
FIG. 7 is a method for operating the vehicle simulator.

### DETAILED DESCRIPTION OF ILLUSTRATIVE EMBODIMENTS

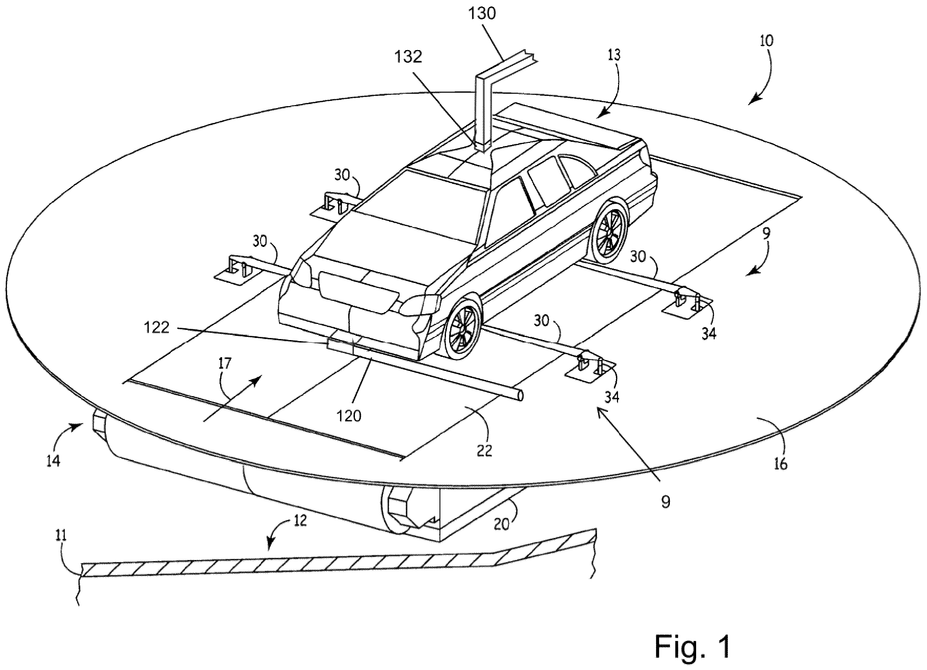

Referring to FIG. 1, an exemplary vehicle restraint 9 and roadway simulator 10 having one or more aspects of the invention is illustrated. In the embodiment illustrated, a vehicle 13 is an automobile; however, it should be understood that this is but one example of a vehicle that can benefit from aspects of the present invention. For that matter, any type of test article restrained relative to a moving surface provided by an endless belt or drums can benefit from one or more aspects of the present invention; however, particular advantages are realized for a vehicle moving over a roadway surface.

In the embodiment illustrated, the simulator 10 includes a support base 11, which generally can comprise a large concrete structure having a pit indicated generally at 12 in which the main roadway mechanisms 14 are mounted so that the vehicle 13 to be tested is at about the level of the surface surrounding the pit 12. In many instances, the simulator 10 forms part of a wind tunnel having a fan, not shown, but represented by arrow 17. The vehicle 13 and the main roadway mechanism 14 can include a platform 16, which, in the embodiment illustrated, is a turntable that allows the vehicle 13 to be positioned selectively with respect to the air flow 17 generated by the fan.

The platform 16 and the main roadway mechanisms 14, although not necessary, can be mounted on a balance assembly, schematically illustrated at 20, which can measure various forces upon the vehicle 13. Such balance assemblies, which can take many forms, are well known in the art and need not be further discussed for purposes of the present application.

It should also be noted that the roadway mechanism 14 illustrated in Fig. 1 includes a single endless belt 22 upon which the vehicle 13 is supported. As appreciated by those skilled in the art, aspects of the present invention can be applied to roadway mechanisms that comprise two or more belts used to support the vehicle 13 and/or are positioned under various portions or proximate to panels of the vehicle 13. All of the belts, if more than one is present, are driven by suitable motors and rollers, the details of which are well known, and not necessary for understanding aspects of the present invention.

Referring now to the vehicle restraint 9, in one form, the vehicle restraint 9 restrains and can control the position of the vehicle 13 on the belt(s) 22, and in particular, control a vertical position of the vehicle and/or measure loads or forces on the vehicle 13. The restraint 9 can have the ability to lift the vehicle 13 upwardly relative to the platform 16 or belt 22 so as to perform work upon the vehicle 13 such as to access the underside of the vehicle 13 to replace components. The restraint 9 should have as minimal effect on air flow around the vehicle 13 as possible during testing. As such supports 30 that extend from "stationary" portions of the platform 16 (relative to movement of the belt 22) on opposite sides of the vehicle 13 over portions of the belt 22 are provided. The supports 30 are axially (along their longitudinal length) rigid or stiff and generally aerodynamic (e.g. slender and/or streamlined in shape) to minimize airflow disturbance.

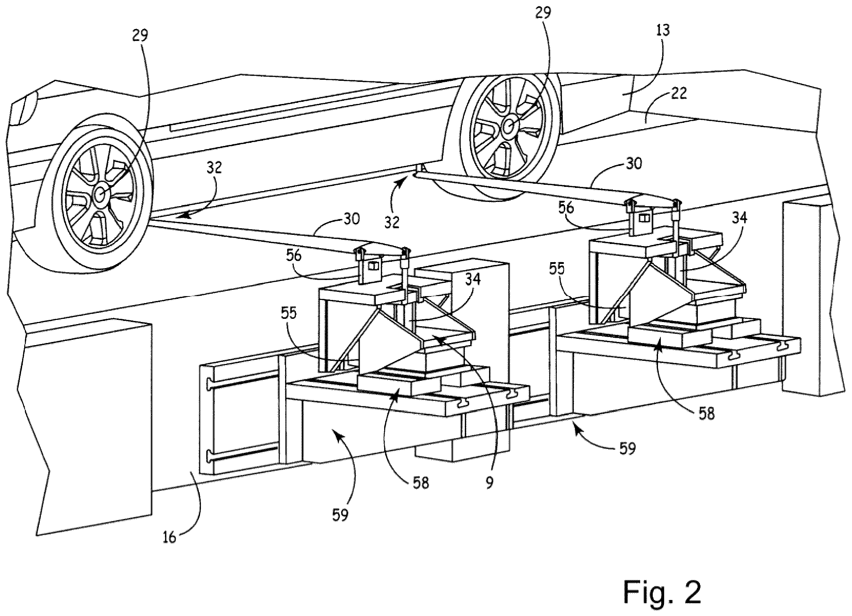

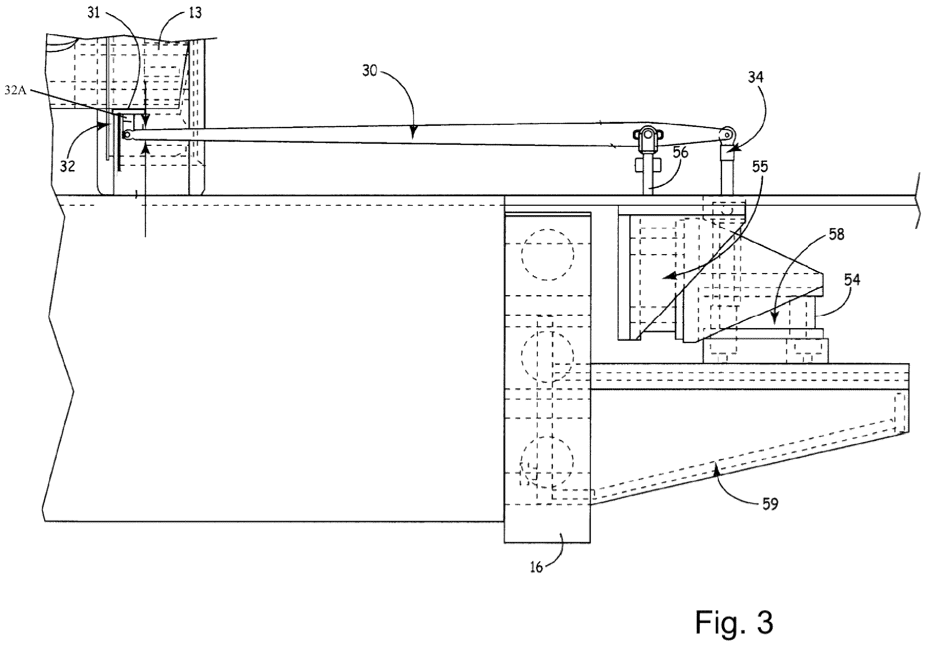

Referring to FIGS. 2 and 3, couplers 32 are coupled to attachment points 31 of the vehicle 13, which may already be available, or may require slight modification such as by providing suitable flanges, thereby allowing the vehicle to be rolled onto the belt 22 and quickly secured. In many instances, each coupler 32 includes an actuator 32A that can be selectively operated so as to operate a coupling to couple and decouple the coupler 32 to a portion of the attachment point 31 of the vehicle 13. The actuator 32A can comprise an electrical, pneumatic or hydraulic mechanism as is known in the art.

In general, each of couplers 32 is joined through each respective support 30 to an actuator assembly 34. The actuator assembly 34 allows a remote end of the support 30 to be positioned proximate the portion of the vehicle 13 to which the coupler 32 will be attached. If desired, selective control of each of the actuators 34, allows the operator to obtain desired characteristics of the vehicle 13 such as vehicle position, ride height, etc., which furthermore can be adjusted while the vehicle 13 is rolling on the belt 22. In addition, if desired, the actuators 34 can be controlled so as to lift the vehicle 13 completely off the belt 22.

In the embodiment illustrated, each support 30 is pivotally coupled to a support fixture 56 where an end of each support 30 remote from the vehicle 13 is coupled to the lift actuator 34. In view that each support pivots at or on a support fixture 56, it may be necessary to provide lateral compensation. In the embodiments illustrated in FIGS. 1-3, compensation is provided by a lateral positioner 58 that can carry the lift actuator 34 and support fixture 56 as well as a load cell 54 that measures horizontal loads (generally transverse and / or parallel to simulated vehicle motion) and a load cell 55 that measures vertical loads (generally orthogonal to simulated vehicle motion). The positioner 58 can take many forms as appreciated by those skilled in the art. Commonly, the positioner 58 includes two elements moving via a guide track under the control of an actuator with suitable sensors providing position information back to a controller. In a further embodiment, the lateral positioner 58 is also supported on platform 16 by a longitudinal positioner 59. Like the lateral positioner 58, the longitudinal positioner 59 can take many forms as appreciated by those skilled in the art. Commonly, the positioner 59 includes two elements moving via a guide track under the control of an actuator with suitable sensors providing position information back to the controller. The longitudinal positioner 59 allows longitudinal positioning of each corresponding support 30. If desired, as is known in the art, suitable couplers can be provided on the end of each support 30 to connect the support 30 to a wheel hub 29 (Fig. 2).

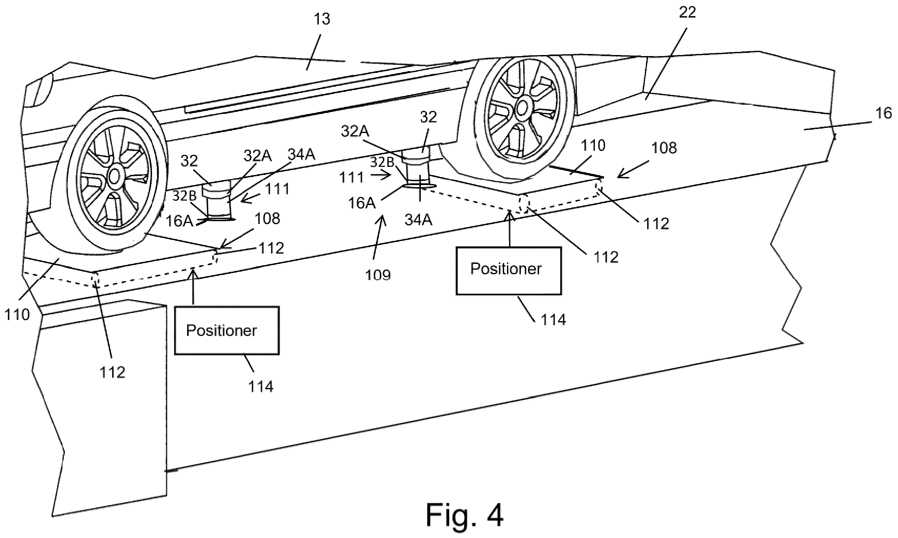

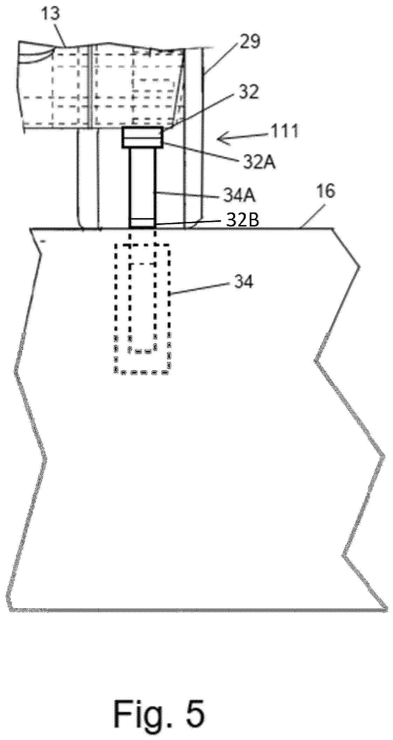

Figs. 4-5 illustrate another embodiment of a restraint system 109 comprising spaced apart restraints 111 mounted to a support structure such as platform 16 for instance directly below the portion of the vehicle 13 to which it is coupled. In this embodiment, the roadway simulator 10 comprises a plurality of rotatable assemblies 108, wherein a separate rotatable assembly 108 is provided for each wheel of the vehicle 13. Each rotatable assembly 108 can comprise one or more or rollers in contact with each tire of the vehicle 13, while in another embodiment, each rotatable assembly 108 comprises an endless belt driven 110 by rollers 112 as is well known in the art. A center belt or endless member 22 can be disposed between the rotatable assemblies 108 and although not in contact with the vehicle 13 can simulate movement of the vehicle 13 over a center portion of a road. Each rotatable assembly 108 can be mounted so as to be stationary in a relative position with respect to the platform 16 albeit rotating each corresponding wheel 29 of the vehicle 13. However, in another embodiment, a positioner 114 (schematically illustrated) can be provided so as to support each rotatable assembly 108 while allowing the overall position of the rotatable assembly 108 to move in longitudinal, lateral and/or vertical directions, thus imparting forces and/or displacements to each wheel of the vehicle 13 so as to emulate travel over a road that is not always flat. Positioners 114 for rotatable assemblies 114 include suitable actuators and guide structures (similar to that of positioners 58 and 59) and are well known in the art.

Restraints 111 include the coupler 32, the actuator 32A and the actuator 34 herein directly coupled below the coupler to the platform 16, where an actuator rod 34A extends through an aperture 16A in the platform 16. Operation of the actuator 34 positions the coupler 32 against the vehicle 13 allowing the actuator 32A to be operated to couple or decouple the vehicle 13 to the platform 16. Preferably, the actuator 34 and coupler 32 are configured such that when fully retracted the coupler 32 is positioned at or below the platform 16 such that the vehicle 13 can travel over the restraints 111 without difficulty thereby allowing the vehicle 13 to be moved on and off the platform 16 when needed.

In a further embodiment, restraint 111 can include an additional actuator 32B spaced apart from actuator 32A, herein disposed closer to the platform 16. Operation of both actuators 32A and 32B so as to decouple the vehicle 13 from the actuator 34 would allow a large extent of the restraint 111 to fall away from both the vehicle 13 and the actuator 34 thus allowing the vehicle 13 to be moved without being inhibited by the restraint 111. With the addition of actuator 32B, the actuator 34 would not need to be operated so as to retract its actuator rod 34A into the aperture 16A and below the platform 16.

At this point, it should be noted that alternative restraint systems can be used and the present invention is not limited to the embodiments described above. Referring back to Fig. 1, in yet another restraint system, a restraint arm or support 120 includes a coupler 122 functionally similar to coupler 32 in that it can include an actuator 122A to selectively couple the coupler 122 to a front portion of the vehicle 13, while a similar support and coupler can be provided for a rear portion of the vehicle 13 if desired. Although illustrated as an arm, it should be noted the support can also be a cable, strap or the like extending forwardly that operates in tension to hold the position of the vehicle 13 on the simulator 10.

Likewise, a support 130 can be provided from above having a coupler 132 having an actuator 132A on an end thereof that is selectively coupled to an upper portion of the vehicle 134. A suitable positioner, not shown, can be coupled to the support 122, the support 130, or the end of the cable or strap, and include one or more actuators so as to allow positioning of the attached coupler and/or provide restraint but also allow some limited movement of the vehicle 13 on the simulator 10. If desired, additional actuators can be included in the supports 122 or 130, or other components of the restraint, in a manner like actuator 32B with actuator 32A, so that other portions of the restraint can break away when it is desired to remove the vehicle 13, again possibly avoiding the need to operate a positioning actuator of the restraint to move the restraint out of the way of the vehicle after operation of an actuator that decouples the restraint from the vehicle.

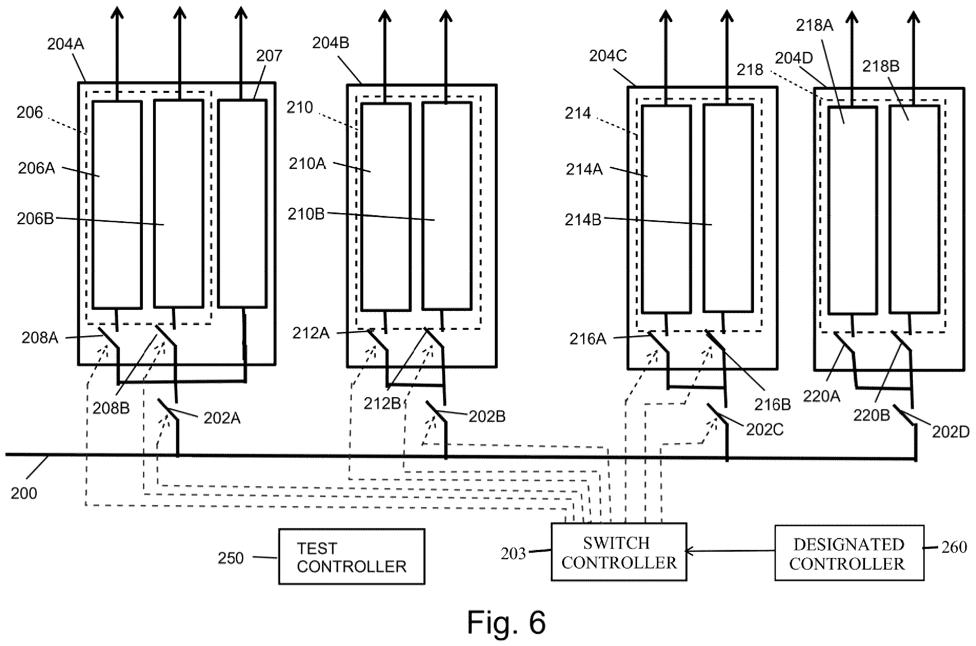

Fig. 6 schematically illustrates electrical cabinetry and power lines for supplying electrical power to various systems of the roadway simulator 10. In Fig. 6, electrical power is from a main power line 200 having switches 202A, 202B, 202C and 202D controlling electrical power to individual cabinets 204A, 204B, 204C and 204D containing circuity for various systems of the simulator 10, the switches 202A, 202B, 202C and 202D being schematically shown as operated from a switch controller 203. For instance, cabinet 204A includes circuity for actuators for any of the couplers described above. Generally, the circuitry comprises an actuator drive assembly 206 having an actuator control module 206A used to control the actuator(s) of the coupler(s) as well as an actuator electrical power supply 206B that provides electrical power to power the actuator(s) directly such when the actuator(s) is electrical in nature such as being a solenoid, linear or rotary electric actuator, or motor for a screw-type actuator. In alternative forms, the actuator electrical power supply 206B would supply electrical power to pneumatic or hydraulic pumps, if the actuator(s) is pneumatic or hydraulic. Each of the actuator control module 206A and the actuator electrical power supply 206B are selectively energized with a power control switch 208A and 208B. Again, Fig. 6 is schematic in that the actuator control module 206A and the actuator electrical power supply 206B are shown located in the same electrical cabinet, but this may not be the case if the power or voltage requirements require that the actuator control module 206A and the actuator electrical power supply 206B be located in separate cabinets. Nevertheless the actuator control module 206A and the actuator electrical power supply 206B are used together to operate the coupling actuator(s) e.g. 32A, 122A or 132A to which they are operably connected.

Similarly, cabinet 204B illustrates an actuator control module 210A and an actuator electrical power supply 210B of another actuator drive assembly 210 for actuators e.g. 34 used in positioning the support arms, rods, cables or straps. Each of the actuator control module 210A and the actuator electrical power supply 210B are selectively energized with a power control switch 212A and 212B. Again, Fig. 6 is schematic in that the actuator control module 210A and the actuator electrical power supply 210B are shown located in the same electrical cabinet, but this may not be the case if the power or voltage requirements require that the actuator control module 210A and the actuator electrical power supply 210B be located in separate cabinets nevertheless the actuator control module 210A and the actuator electrical power supply 210B are used together to operate the actuator(s) to which they are connected.

Likewise, cabinet 204C illustrates an positioner control module 214A and a positioner electrical power supply 214B of a positioner drive assembly 214 for any component of the simulator 10 that may need to be moved in order to remove the vehicle 13 from the simulator 10. For instance, such a positioner may be positioner 114 used to control the position of one the rotatable assemblies 108 such that rotatable assembly 108 can be positioned relative to the surface 16 so the vehicle 13 can be moved along the surface 16. The positioner could also be a drive assembly used to rotate the surface 16 if it comprises a turntable. The positioner control module 214A and the positioner electrical power supply 214B are selectively energized with a power control switch 216A and 216B. Again, Fig. 6 is schematic in that the positioner control module 214A and the positioner electrical power supply 214B are shown located in the same electrical cabinet, but this may not be the case if the power or voltage requirements require that the positioner control module 214A and the positioner electrical power supply 214B be located in separate cabinets nevertheless the positioner control module 214A and the positioner electrical power supply 214B are used together to operate the positioner to which they are connected.

Lastly, in the schematic illustration of Fig. 6, cabinet 204D illustrates a rotatable drive control module 218A and a rotatable drive electrical power supply 218B of a rotatable drive assembly 218 for a rotatable assembly 108 of the simulator 10. The rotatable drive control module 218A and the rotatable drive electrical power supply 214B are selectively energized with a power control switch 220A and 220B. Again, Fig. 6 is schematic in that the rotatable drive control module 218A and the rotatable drive electrical power supply 218B are shown located in the same electrical cabinet, but this may not be the case if the power or voltage requirements require that the rotatable drive control module 218A and the rotatable drive electrical power supply 218B be located in separate cabinets nevertheless the rotatable drive control module 218A and the rotatable drive electrical power supply 218B are used together to operate the rotatable drive to which they are connected.

All the switches 208A-208B, 212A-212B, 216A-216B and 220A-220B are schematically shown as operated by switch controller 203; however, a separate switch controller could be used separate from switch controller 203 if desired.

In normal operation, the vehicle 13 is positioned on the roadway simulator 10 and is coupled thereto with a restraint assembly such as any of the restraint assemblies, for example, 9 or 109 described above or similar such functioning restraint assemblies. A controller 250 (Fig. 6) is used to control the roadway simulator 10 as needed to conduct the desired test to be performed on the vehicle 13. (The test controller 250 is operably coupled to the control modules and power supplies described above wherein the control lines have been omitted to enhance understanding of other aspects shown. With respect to the electrical schematic of Fig. 6, the switches 202A-202D, 208A-208B, 212A-212B, 216A-216B and 220A-220B are closed as necessary to conduct the test. For instance, the rotatable drive assemblies 108 are operated to simulate desired speed of travel of the vehicle 13 along a road. If provided positioners 114 can impart forces or displacements to individual wheels of the vehicle 13 as desired. If located in a wind tunnel the wind tunnel fan can be operated to generate air flow upon the vehicle 13, and the turntable 16, if also provided, can change the angular position of the vehicle 13 with respect to the air flow 17.

However, it is possible that during a test or otherwise, it becomes necessary that the vehicle 13 needs to be removed from the simulator 10 such as when the vehicle 13 may be on fire and its presence on the simulator 10 could cause significant damage to the simulator 10. The electrical circuitry and switch control illustrate in Fig. 6 enables safe removal of the vehicle 13 from the simulator 10 when such a situation exists.

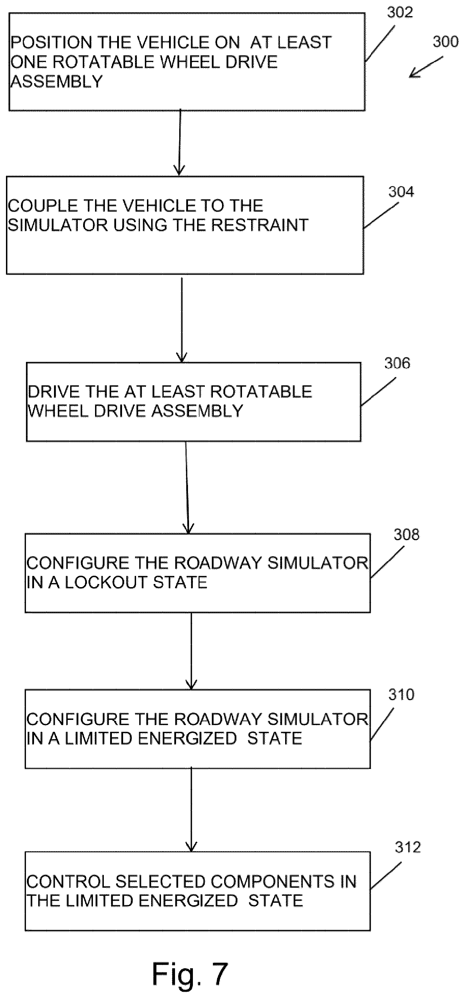

FIG. 7 illustrates a method 300 for testing a vehicle 13 on the roadway simulator 10 having at least one rotatable assembly 108 for rotating at least one wheel of the vehicle 13. The method 300 includes at step 302 positioning the vehicle 13 on the at least one rotatable assembly 108.

At step 304 a restraint e.g. 9, 109 is coupled to the vehicle 13 so as to limit longitudinal and/or lateral movement of the vehicle 13 on the at least one rotatable assembly 108. The coupling includes controlling the first actuator e.g. 34 to position and end of the restraint 9, 109 approximate a portion of the vehicle 13 and/or controlling an actuator e.g. 32A, 122A, 132A to couple the restraint to a portion of the vehicle 13.

At step 306 the at least one rotatable assembly 108 is driven so as to rotate the at least one wheel on the vehicle 13 during a normal test desired to be performed on the vehicle 13. Typically, this would include operating most if not all the desired sub-assemblies or mechanisms of the roadway simulator 10 provided, which includes powering all of the cabinets such as cabinets 204A-204D illustrated in FIG. 6 among many other that are not shown since they pertain to the normal operation of a test.

During operation of the test or typically in close proximity time to conducting a test, the operator becomes aware of a problem with the vehicle 13 under test requiring that it should be removed from the roadway simulator 10 as soon as possible. Typically, the operator will initiate an emergency stop or the like through test controller 250 or other suitable switch, which removes most of if not all electrical power being provided to the roadway simulator 10 through the electrical cabinets 204A-204D schematically illustrated in FIG. 6. For instance, the emergency stop will commonly cause many if not all of the control switches 202A-202D and/or switches 208A-208B, 212A-212B, 216A-216B and 220A-220B to open so as to remove electrical power from the cabinets 204A-204D. As used herein the roadway simulator 10 is now in a "lockout state" wherein power is isolated from the components of the roadway simulator 10 and thus with such power removed inhibits operation for conducting a test. The "lockout state" includes isolating electrical power from any and all rotatable drive assemblies 218 for the rotatable assemblies 108. The "lockout state" also isolates electrical power from actuator and drive assemblies 208, 206 for the actuator 34 and/or the actuator 32A, 32B 122A, 132A. The "lockout state" typically would also operate the control switches 220A-220B for the rotatable drive assembly 218.

As indicated above, in this situation there is a desire to remove the vehicle 13 from the roadway simulator 10 and in order to do so an aspect of the present invention allows selective energization of those components needed to decouple the vehicle 13 from the roadway simulator 10. At step 310 the roadway simulator 10 is configured in a "limited energized state", which as used herein entails that testing of the vehicle 13 is inhibited due to continued isolation of electrical power to the rotatable drive assembly 218 and wherein electrical power is restored to the actuator drive assembly 206, 210 for the actuator 34 and/or the actuator 32A, 32B 122A, 132A. The "limited energized state" is achieved by providing control signals to operate each of the switches of the control switches 208A-208B, 212A-212B and 216A-216B as needed. However, again, power is not provided to many other components of the road simulator 10 that are not needed to remove the vehicle 13 from the simulator 10 such as the rotatable drive assembly 218.

At this point it should be noted that it is not necessary that the simulator include all the switches 208A-208B, 212A-212B, 216A-216B and 220A-220B as illustrated in order to achieve the lockout state and the limited energized state. If desired, these states can be achieved by control of switches 202A-202D for each of the cabinets 204A-204D, where a single control switch could also selectively provide power to two or more cabinets. To achieve the limited energized state, switches 202A-202C are selectively operated to provide power to the control modules and power supplies needed for operation of the actuators so as to release the restraints and move them such that the vehicle 13 can be moved. Sometimes a cabinet may include other modules, power supplies, circuitry of the like such as indicated at 207 in Fig. 6 that might be energized along with the control modules and power supplies needed for operation of the actuators so as to release the restraints and move them such that the vehicle 13 can be moved, however, this is typically not a problem since energization will only be temporary to the extent needed to remove the vehicle 13.

At step 312, with the simulator 10 powered in the limited energized state, the actuator e.g. 34 is controlled to position the end of the restraint remote from the vehicle 13 to allow the vehicle 13 to be removed from the at least one rotatable assembly 108 and/or the actuator 32A, 32B 122A, 132A is controlled so as to decouple the restraint from the portion of the vehicle 13.

Fig. 6 illustrates a designated control or controller 260 that is operated by the operator to place the simulator in the limited energized state where at least the actuator drive assemblies 206 and/or 210 are energized such that the actuators powered and controlled thereby can be operated as desired to decouple the vehicle and/or reposition the restraints out of the way such that vehicle 13 can be removed from the simulator 10. In one embodiment, the designated control 260 is remote from a user interface for operating the roadway simulator to perform the test of the vehicle by controlling the at least one rotatable assembly such that inadvertent operation of the designated control 260 is inhibited. For instance, the designated control 260 can be located on a separate panel from the user interface for the controller 250 used to conduct a test. The designated control 260 could entail use of a key to operate the control 260 or otherwise gain access to it.

In another embodiment, the designated control 260 can be part of the user interface used for conducting a test, but access to the designated control 260 could possibly entail switching to a different screen rendered on the user interface, or otherwise require certain operation of buttons or the like on the rendered screen to gain access to it.

In Fig. 6, the designated controller 260 is operably coupled to the switch controller 203 so as to provide command signals to operate switches 208A-208B and 212A-212B as needed. However, it should be understood that designated controller 260 may be operably connected to switches 208A-208B and 212A-212B without using switch controller 203 if desired.

The term coupled, as used herein, is defined as connected, although not necessarily directly.

## Claims

1. A method (300) for testing a vehicle (13) on a roadway simulator (10) having at least one rotatable assembly (16) for rotating at least one wheel of the vehicle, the method comprising:
positioning (302) the vehicle on the at least one rotatable assembly;
coupling (304) a restraint (9, 109) to the vehicle so as to limit longitudinal and/or lateral movement of the vehicle on the at least one rotatable assembly, wherein coupling includes controlling a first actuator (34) to position an end of the restraint proximate a portion of the vehicle and controlling a second actuator (32A, 122A, 132A) to couple the restraint to the portion of the vehicle;
driving (306) the at least one rotatable assembly to rotate the at least one wheel on the vehicle;
configuring (308) the roadway simulator in a lockout state wherein power is isolated from roadway simulator that inhibits operation for conducting a test including isolating electrical power from a rotatable drive assembly for the at least one rotatable assembly and for isolating electrical power from an actuator drive assembly for the first actuator and/or the second actuator;
configuring (310) the roadway simulator in a limited energized state wherein testing of the vehicle is inhibited due to continued isolation of electrical power to the rotatable drive assembly and wherein electrical power is restored to the actuator drive assembly for the first actuator and/or the second actuator; and
controlling (312) the first actuator to position the end of the restraint remote from the vehicle to allow the vehicle to be removed the at least one rotatable assembly and/or controlling the second actuator to decouple the restraint from the portion of the vehicle.

2. The method of claim 1, wherein the roadway simulator includes a designated control for configuring the roadway simulator in the limited energized state, and wherein configuring the roadway simulator in the limited energization state includes providing a control signal from the designated control to energize circuitry for the first and/or second actuator, wherein in one embodiment, the designated control is remote from a user interface for operating the roadway simulator to perform the test of the vehicle by controlling the at least one rotatable assembly, and in another embodiment, designated control is part of a user interface for operating the roadway simulator to perform the test of the vehicle by controlling the at least one rotatable assembly.

3. The method of claim 2, wherein providing the control signal includes providing a control signal to a first controlled switch to operate the first controlled switch to provide electrical power to the actuator drive assembly for the first actuator and/or the second actuator, in one embodiment, wherein designated control is not configured to operate a switch that provides electrical power to the rotatable drive assembly.

4. The method of claim 2, wherein the actuator drive assembly comprises an actuator electrical power supply providing power to the first actuator and/or the second actuator and an actuator control module connected to the actuator electrical power supply and configured to control operation of the actuator electrical power supply, in one embodiment, wherein a power supply switch selectively provides electrical power to the actuator electrical power supply, and a control module switch selectively provides electrical power to the actuator control module, and wherein providing the control signal operates the power supply switch to provide electrical power to the actuator electrical power supply, and operates the control module switch to provide electrical power to the actuator control module, and in a further embodiment, wherein power supply switch selectively provides electrical power to another portion of the roadway simulator different than the actuator electrical power supply, the another portion of the roadway simulator having another control module different than the actuator control module, wherein providing the control signal does not provide electrical power to the another control module.

5. The method of claim 2, wherein roadway simulator comprises a positioner for controlling a position of an element of the roadway simulator, and wherein configuring the roadway simulator in the lockout state comprises isolating electrical power to a positioner drive assembly of the positioner, and wherein configuring the roadway simulator in the limited energized state, comprises restoring electrical power to the positioner drive assembly, in one embodiment, wherein the positioner positions the element in a selected position to allow removal of the vehicle from the roadway simulator, in another embodiment, wherein the roadway simulator comprises a turntable supporting the vehicle in selected angular positions, and the positioner drive assembly rotates the turntable, or wherein the positioner is coupled to the at least one rotatable assembly, or wherein the positioner drive assembly comprises a positioner electrical power supply providing power to the positioner and a positioner control module connected to the positioner electrical power supply and configured to control operation of the positioner electrical power supply.

6. The method of claim 5, wherein a positioner power supply switch selectively provides electrical power to the positioner electrical power supply, and a positioner control module switch selectively provides electrical power to the positioner control module, and wherein providing the control signal operates the positioner power supply switch to provide electrical power to the positioner electrical power supply, and operates the positioner control module switch to provide electrical power to the positioner control module.

7. The method of any of the previous claims, wherein coupling the restraint to the vehicle comprises coupling the restraint to a side portion of the vehicle, or to an end portion of the vehicle, or to an upper portion of the vehicle.

8. The method of any of the previous claims, wherein the first actuator adjusts a position of the end of the restraint, and the second actuator operates a coupler that couples the restraint to the vehicle.

9. The method of any of the previous claims, wherein the at least one rotatable assembly comprises a single belt supporting and rotatably driving each wheel of the vehicle, or each separate rotatable assembly rotatably driving at least one wheel of the vehicle,
each separate rotatable assembly rotatably driving one wheel of the vehicle.

10. A roadway simulator (10) comprising:
at least one rotatable assembly (16) for rotating at least one wheel of vehicle (13);
a restraint (9, 109) couplable to a vehicle so as to limit longitudinal and/or lateral movement of the vehicle on the at least one rotatable assembly, wherein the restraint includes a first actuator (34) to position an end of the restraint proximate a portion of the vehicle and a second actuator (32A, 122A, 132A) to couple the restraint to the portion of the vehicle;
a controller (250) operable to configure the roadway simulator in a lockout state wherein power is isolated from roadway simulator that inhibits operation for conducting a test including isolating electrical power from a rotatable drive assembly for the at least one rotatable assembly and for isolating electrical power from an actuator drive assembly for the first actuator and/or the second actuator, and operable to configure the roadway simulator in a limited energized state wherein testing of the vehicle is inhibited due to continued isolation of electrical power to the rotatable drive assembly and wherein electrical power is restored to the actuator drive assembly for the first actuator and/or the second actuator.

11. The roadway simulator of claim 10, further comprising a designated control for configuring the roadway simulator in the limited energized state, and wherein the designated control provides a control signal to energize circuitry for the first and/or second actuator.

12. The roadway simulator of claim 11, wherein the designated control is remote from a user interface for operating the roadway simulator to perform the test of the vehicle by controlling the at least one rotatable assembly.

13. The roadway simulator of claim 11, wherein the designated control is part of a user interface for operating the roadway simulator to perform the test of the vehicle by controlling the at least one rotatable assembly

## Patentansprüche

1. Verfahren (300) zum Testen eines Fahrzeugs (13) auf einem Fahrbahnsimulator (10) mit mindestens einer drehbaren Baugruppe (16) zum Drehen mindestens eines Rads des Fahrzeugs, wobei das Verfahren Folgendes aufweist:
das Positionieren (302) des Fahrzeugs auf der mindestens einen drehbaren Baugruppe;
das Koppeln (304) eines Rückhaltemittels (9, 109) mit dem Fahrzeug, um die Längs- und/oder Querbewegung des Fahrzeugs auf der mindestens einen drehbaren Baugruppe zu begrenzen, wobei das Koppeln das Steuern eines ersten Aktuators (34) beinhaltet, um ein Ende des Rückhaltemittels in der Nähe eines Abschnitts des Fahrzeugs zu positionieren, und das Steuern eines zweiten Aktuators (32A, 122A, 132A) beinhaltet, um das Rückhaltemittel mit dem Abschnitt des Fahrzeugs zu koppeln;
das Antreiben (306) der mindestens einen drehbaren Baugruppe, um das mindestens eine Rad am Fahrzeug zu drehen;
das Konfigurieren (308) des Fahrbahnsimulators in einem Sperrzustand, in dem Energie von dem Fahrbahnsimulator isoliert ist, der den Betrieb zum Durchführen eines Tests verhindert, beinhaltend das Isolieren elektrischer Energie von einer drehbaren Antriebsbaugruppe für die mindestens eine drehbare Baugruppe und das Isolieren elektrischer Energie von einer Stellantriebsbaugruppe für den ersten Aktuator und/oder den zweiten Aktuator;
das Konfigurieren (310) des Fahrbahnsimulators in einem begrenzten bestromten Zustand, in dem das Testen des Fahrzeugs aufgrund einer fortgesetzten Isolierung von elektrischer Energie für die drehbare Antriebsbaugruppe verhindert wird und in dem elektrische Energie an die Stellantriebsbaugruppe für den ersten Aktuator und/oder den zweiten Aktuator wiederhergestellt wird; und
das Steuern (312) des ersten Aktuators, um das Ende des Rückhaltemittels, das von dem Fahrzeug entfernt ist, zu positionieren, um zu ermöglichen, dass das Fahrzeug von der mindestens einen drehbaren Baugruppe entfernt wird, und/oder das Steuern des zweiten Aktuators, um das Rückhaltemittel von dem Abschnitt des Fahrzeugs zu entkoppeln.

2. Verfahren nach Anspruch 1, wobei der Fahrbahnsimulator eine bestimmte Steuerung zum Konfigurieren des Fahrbahnsimulators in dem begrenzten bestromten Zustand beinhaltet, und wobei das Konfigurieren des Fahrbahnsimulators in dem begrenzten bestromten Zustand das Bereitstellen eines Steuersignals von der bestimmten Steuerung beinhaltet, um eine Schaltung für den ersten und/oder zweiten Aktuator zu bestromen, wobei in einer Ausführungsform die bestimmte Steuerung von einer Benutzerschnittstelle zum Betreiben des Fahrbahnsimulators entfernt ist, um den Test des Fahrzeugs durch Steuern der mindestens einen drehbaren Baugruppe durchzuführen, und in einer anderen Ausführungsform die bestimmte Steuerung Teil einer Benutzerschnittstelle zum Betreiben des Fahrbahnsimulators ist, um den Test des Fahrzeugs durch Steuern der mindestens einen drehbaren Baugruppe durchzuführen.

3. Verfahren nach Anspruch 2, wobei das Bereitstellen des Steuersignals das Bereitstellen eines Steuersignals an einen ersten gesteuerten Schalter beinhaltet, um den ersten gesteuerten Schalter zu betätigen, um der Stellantriebsbaugruppe für den ersten Aktuator und/oder den zweiten Aktuator elektrische Energie bereitzustellen, in einer Ausführungsform, wobei die bestimmte Steuerung nicht dazu eingerichtet ist, einen Schalter zu betätigen, der elektrische Energie an die drehbare Antriebsbaugruppe bereitstellt.

4. Verfahren nach Anspruch 2, wobei die Aktuatorantriebsanordnung eine elektrische Aktuatorstromversorgung aufweist, die dem ersten Aktuator und/oder dem zweiten Aktuator mit Energie bereitstellt, und ein Aktuatorsteuermodul, das mit der elektrischen Aktuatorstromversorgung verbunden ist und dazu eingerichtet ist, den Betrieb der elektrischen Aktuatorstromversorgung zu steuern, in einer Ausführungsform, wobei ein Stromversorgungsschalter selektiv elektrische Energie an die elektrische Aktuatorstromversorgung bereitstellt und ein Steuermodulschalter selektiv elektrische Energie an das Aktuatorsteuermodul bereitstellt, und wobei das Bereitstellen des Steuersignals den Stromversorgungsschalter betätigt, um elektrische Energie an die elektrische Aktuatorstromversorgung bereitzustellen, und den Steuermodulschalter betätigt, um elektrische Energie an das Aktuatorsteuermodul bereitzustellen, und in einer weiteren Ausführungsform, wobei der Stromversorgungsschalter selektiv elektrische Energie an einen anderen Teil des Fahrbahnsimulators bereitstellt, der sich von der elektrischen Aktuatorstromversorgung unterscheidet, wobei der andere Teil des Fahrbahnsimulators ein anderes Steuermodul aufweist, das sich von dem Aktuatorsteuermodul unterscheidet, wobei das Bereitstellen des Steuersignals dem anderen Steuermodul keine elektrische Energie bereitstellt.

5. Verfahren nach Anspruch 2, wobei der Fahrbahnsimulator einen Positionierer zum Steuern einer Position eines Elements des Fahrbahnsimulators aufweist, und wobei das Konfigurieren des Fahrbahnsimulators in dem Sperrzustand das Isolieren elektrischer Energie von einer Positionierer-Antriebsanordnung des Positionierers aufweist, und wobei das Konfigurieren des Fahrbahnsimulators in dem begrenzt bestromten Zustand das Wiederherstellen elektrischer Energie für die Positionierer-Antriebsanordnung aufweist, in einer Ausführungsform, wobei der Positionierer das Element in einer ausgewählten Position positioniert, um das Entfernen des Fahrzeugs aus dem Fahrbahnsimulator zu ermöglichen, in einer anderen Ausführungsform, wobei der Fahrbahnsimulator einen Drehteller aufweist, der das Fahrzeug in ausgewählten Winkelpositionen trägt, und die Positionierer-Antriebsanordnung den Drehteller dreht, oder wobei der Positionierer mit der mindestens einen drehbaren Anordnung gekoppelt ist, oder wobei die Positionierer-Antriebsanordnung eine elektrische Positionierer-Stromversorgung aufweist, die dem Positionierer Energie bereitstellt, und ein Positionierer-Steuermodul, das mit der elektrischen Positionierer-Stromversorgung verbunden ist und dazu eingerichtet ist, den Betrieb der elektrischen Positionierer-Stromversorgung zu steuern.

6. Verfahren nach Anspruch 5, wobei ein Positionierer-Stromversorgungsschalter selektiv elektrische Energie an die elektrische Positionierer-Stromversorgung bereitstellt und ein Positionierer-Steuermodulschalter selektiv elektrische Energie an das Positionierer-Steuermodul bereitstellt, und wobei das Bereitstellen des Steuersignals den Positionierer-Stromversorgungsschalter betätigt, um elektrische Energie an die elektrische Positionierer-Stromversorgung bereitzustellen, und den Positionierer-Steuermodulschalter betätigt, um elektrische Energie an das Positionierer-Steuermodul bereitzustellen.

7. Verfahren nach einem der vorhergehenden Ansprüche, wobei das Koppeln der Rückhalteeinrichtung mit dem Fahrzeug das Koppeln der Rückhalteeinrichtung mit einem Seitenabschnitt des Fahrzeugs oder mit einem Endabschnitt des Fahrzeugs oder mit einem oberen Abschnitt des Fahrzeugs aufweist.

8. Verfahren nach einem der vorhergehenden Ansprüche, wobei der erste Aktuator eine Position des Endes der Rückhalteeinrichtung einstellt und der zweite Aktuator einen Koppler betätigt, der die Rückhalteeinrichtung mit dem Fahrzeug koppelt.

9. Verfahren nach einem der vorhergehenden Ansprüche, wobei die mindestens eine drehbare Anordnung einen einzelnen Riemen aufweist, der jedes Rad des Fahrzeugs trägt und drehbar antreibt, oder wobei jede separate drehbare Anordnung mindestens ein Rad des Fahrzeugs drehbar antreibt, wobei jede separate drehbare Anordnung ein Rad des Fahrzeugs drehbar antreibt.

10. Ein Fahrbahnsimulator (10), aufweisend:
mindestens eine drehbare Anordnung (16) zum Drehen mindestens eines Rads eines Fahrzeugs (13);
eine Rückhaltevorrichtung (9, 109), die mit einem Fahrzeug koppelbar ist, um die Längs- und/oder Querbewegung des Fahrzeugs auf der mindestens einen drehbaren Baugruppe zu begrenzen, wobei die Rückhaltevorrichtung einen ersten Aktuator (34) beinhaltet, um ein Ende der Rückhaltevorrichtung in der Nähe eines Abschnitts des Fahrzeugs zu positionieren, und einen zweiten Aktuator (32A, 122A, 132A), um die Rückhaltevorrichtung mit dem Abschnitt des Fahrzeugs zu koppeln;
eine Steuereinheit (250), die betreibbar ist, um den Fahrbahnsimulator in einem Sperrzustand einzurichten, in dem die Energiezufuhr vom Fahrbahnsimulator getrennt ist, was den Betrieb zum Durchführen eines Tests unterbindet, einschließlich des Trennens der elektrischen Energiezufuhr von einer drehbaren Antriebsbaugruppe für die mindestens eine drehbare Baugruppe und des Trennens der elektrischen Energiezufuhr von einer Antriebsbaugruppe für den ersten Aktuator und/oder den zweiten Aktuator, und die betreibbar ist, um den Fahrbahnsimulator in einem begrenzten bestromten Zustand einzurichten, in dem das Testen des Fahrzeugs aufgrund der fortgesetzten Trennung der elektrischen Energiezufuhr zur drehbaren Antriebsbaugruppe unterbunden ist und in dem die elektrische Energiezufuhr zur Antriebsbaugruppe für den ersten Aktuator und/oder den zweiten Aktuator wiederhergestellt ist.

11. Der Fahrbahnsimulator nach Anspruch 10, ferner aufweisend ein vorgesehenes Bedienelement zum Konfigurieren des Fahrbahnsimulators in dem begrenzten bestromten Zustand, und wobei das vorgesehene Bedienelement ein Steuersignal bereitstellt, um eine Schaltung für den ersten und/oder zweiten Aktuator zu bestromen.

12. Der Fahrbahnsimulator nach Anspruch 11, wobei das vorgesehene Bedienelement von einer Benutzerschnittstelle zum Betreiben des Fahrbahnsimulators entfernt ist, um den Test des Fahrzeugs durch Steuern der mindestens einen drehbaren Baugruppe durchzuführen.

13. Der Fahrbahnsimulator nach Anspruch 11, wobei das vorgesehene Bedienelement Teil einer Benutzerschnittstelle zum Betreiben des Fahrbahnsimulators ist, um den Test des Fahrzeugs durch Steuern der mindestens einen drehbaren Baugruppe durchzuführen.

## Revendications

1. Procédé (300) pour tester un véhicule (13) sur un simulateur de route (10) ayant au moins un ensemble rotatif (16) pour entraîner en rotation au moins une roue du véhicule, le procédé comprenant :
le positionnement (302) du véhicule sur au moins un ensemble rotatif ;
l'accouplement (304) d'un dispositif de retenue (9, 109) au véhicule de manière à limiter le mouvement longitudinal et/ou latéral du véhicule sur au moins un ensemble rotatif, dans lequel l'accouplement comprend la commande d'un premier actionneur (34) pour positionner une extrémité du dispositif de retenue à proximité d'une partie du véhicule et la commande d'un deuxième actionneur (32A, 122A, 132A) pour coupler le dispositif de retenue à la partie du véhicule ;
l'entraînement (306) d'au moins un ensemble rotatif pour entraîner en rotation au moins une roue du véhicule ;
la configuration (308) du simulateur de route dans un état de verrouillage dans lequel l'alimentation est coupée du simulateur de route, ce qui inhibe le fonctionnement pour la réalisation d'un essai, comprenant la coupure de l'alimentation électrique d'un ensemble d'entraînement rotatif pour au moins un ensemble rotatif et la coupure de l'alimentation électrique d'un ensemble d'entraînement d'actionneur pour le premier actionneur et/ou le deuxième actionneur ;
la configuration (310) du simulateur de route dans un état sous tension limitée dans lequel l'essai du véhicule est inhibé en raison de la coupure continue de l'alimentation électrique de l'ensemble d'entraînement rotatif et dans lequel l'alimentation électrique est rétablie pour l'ensemble d'entraînement d'actionneur pour le premier actionneur et/ou le deuxième actionneur ; et
la commande (312) du premier actionneur pour positionner l'extrémité du dispositif de retenue éloignée du véhicule afin de permettre au véhicule d'être retiré d'au moins un ensemble rotatif et/ou la commande du deuxième actionneur pour découpler le dispositif de retenue de la partie du véhicule.

2. Procédé selon la revendication 1, dans lequel le simulateur de route comprend une commande désignée pour configurer le simulateur de route dans l'état sous tension limitée, et dans lequel la configuration du simulateur de route dans l'état sous tension limitée comprend la fourniture d'un signal de commande provenant de la commande désignée pour alimenter des circuits pour le premier et/ou le deuxième actionneur, dans lequel, dans un mode de réalisation, la commande désignée est distante d'une interface utilisateur destinée à faire fonctionner le simulateur de route pour réaliser l'essai du véhicule en commandant au moins un ensemble rotatif, et dans un autre mode de réalisation, la commande désignée fait partie d'une interface utilisateur destinée à faire fonctionner le simulateur de route pour réaliser l'essai du véhicule en commandant au moins un ensemble rotatif.

3. Procédé selon la revendication 2, dans lequel la fourniture du signal de commande comprend la fourniture d'un signal de commande à un premier commutateur commandé pour actionner le premier commutateur commandé afin de fournir une puissance électrique à l'ensemble d'entraînement d'actionneur pour le premier actionneur et/ou le deuxième actionneur, dans un mode de réalisation, dans lequel la commande désignée n'est pas configurée pour actionner un commutateur qui fournit une puissance électrique à l'ensemble d'entraînement rotatif.

4. Procédé selon la revendication 2, dans lequel l'ensemble d'entraînement d'actionneur comprend une alimentation électrique d'actionneur fournissant de l'énergie électrique au premier actionneur et/ou au deuxième actionneur, et un module de commande d'actionneur connecté à l'alimentation électrique d'actionneur et configuré pour commander le fonctionnement de l'alimentation électrique d'actionneur, selon un mode de réalisation, dans lequel un commutateur d'alimentation fournit sélectivement de l'énergie électrique à l'alimentation électrique d'actionneur, et un commutateur de module de commande fournit sélectivement de l'énergie électrique au module de commande d'actionneur, et dans lequel la fourniture du signal de commande actionne le commutateur d'alimentation pour fournir de l'énergie électrique à l'alimentation électrique d'actionneur, et actionne le commutateur de module de commande pour fournir de l'énergie électrique au module de commande d'actionneur, et selon un mode de réalisation supplémentaire, dans lequel le commutateur d'alimentation fournit sélectivement de l'énergie électrique à une autre partie du simulateur de route distincte de l'alimentation électrique d'actionneur, ladite autre partie du simulateur de route comportant un autre module de commande distinct du module de commande d'actionneur, dans lequel la fourniture du signal de commande ne fournit pas d'énergie électrique audit autre module de commande.

5. Procédé selon la revendication 2, dans lequel le simulateur de route comprend un positionneur pour commander une position d'un élément du simulateur de route, et dans lequel la configuration du simulateur de route dans l'état de verrouillage comprend l'isolation de l'alimentation électrique d'un ensemble d'entraînement de positionneur du positionneur, et dans lequel la configuration du simulateur de route dans l'état d'excitation limitée comprend le rétablissement de l'alimentation électrique de l'ensemble d'entraînement de positionneur, selon un mode de réalisation dans lequel le positionneur positionne l'élément dans une position sélectionnée pour permettre le retrait du véhicule du simulateur de route, selon un autre mode de réalisation dans lequel le simulateur de route comprend un plateau tournant supportant le véhicule dans des positions angulaires sélectionnées, et l'ensemble d'entraînement de positionneur fait tourner le plateau tournant, ou dans lequel le positionneur est couplé audit au moins un ensemble rotatif, ou dans lequel l'ensemble d'entraînement de positionneur comprend une alimentation électrique de positionneur fournissant de l'énergie au positionneur et un module de commande de positionneur connecté à l'alimentation électrique de positionneur et configuré pour commander le fonctionnement de l'alimentation électrique de positionneur.

6. Procédé selon la revendication 5, dans lequel un commutateur d'alimentation de positionneur fournit sélectivement de l'énergie électrique à l'alimentation électrique de positionneur, et un commutateur de module de commande de positionneur fournit sélectivement de l'énergie électrique au module de commande de positionneur, et dans lequel la fourniture du signal de commande actionne le commutateur d'alimentation de positionneur pour fournir de l'énergie électrique à l'alimentation électrique de positionneur, et actionne le commutateur de module de commande de positionneur pour fournir de l'énergie électrique au module de commande de positionneur.

7. Procédé selon l'une quelconque des revendications précédentes, dans lequel le couplage du dispositif de retenue au véhicule comprend le couplage du dispositif de retenue à une partie latérale du véhicule, ou à une partie d'extrémité du véhicule, ou à une partie supérieure du véhicule.

8. Procédé selon l'une quelconque des revendications précédentes, dans lequel le premier actionneur ajuste une position de l'extrémité du dispositif de retenue, et le deuxième actionneur actionne un coupleur qui couple le dispositif de retenue au véhicule.

9. Procédé selon l'une quelconque des revendications précédentes, dans lequel l'au moins un ensemble rotatif comprend une seule courroie supportant et entraînant en rotation chaque roue du véhicule, ou chaque ensemble rotatif séparé entraînant en rotation au moins une roue du véhicule, chaque ensemble rotatif séparé entraînant en rotation une roue du véhicule.

10. Simulateur de route (10) comprenant :
au moins un ensemble rotatif (16) pour entraîner en rotation au moins une roue d'un véhicule (13) ;
un dispositif de retenue (9, 109) pouvant être couplé à un véhicule de manière à limiter le mouvement longitudinal et/ou latéral du véhicule sur au moins un ensemble rotatif, dans lequel le dispositif de retenue comprend un premier actionneur (34) pour positionner une extrémité du dispositif de retenue à proximité d'une partie du véhicule et un deuxième actionneur (32A, 122A, 132A) pour coupler le dispositif de retenue à la partie du véhicule ;
un dispositif de commande (250) utilisable pour configurer le simulateur de route dans un état de verrouillage dans lequel l'alimentation est isolée du simulateur de route, ce qui inhibe le fonctionnement pour réaliser un essai comprenant l'isolation de l'alimentation électrique d'un ensemble d'entraînement rotatif pour au moins un ensemble rotatif et l'isolation de l'alimentation électrique d'un ensemble d'entraînement d'actionneur pour le premier actionneur et/ou le deuxième actionneur, et utilisable pour configurer le simulateur de route dans un état de mise sous tension limitée dans lequel l'essai du véhicule est inhibé en raison de l'isolation continue de l'alimentation électrique de l'ensemble d'entraînement rotatif et dans lequel l'alimentation électrique est rétablie pour l'ensemble d'entraînement d'actionneur pour le premier actionneur et/ou le deuxième actionneur.

11. Le simulateur de route selon la revendication 10, comprenant en outre une commande désignée pour configurer le simulateur de route dans l'état de mise sous tension limitée, et dans lequel la commande désignée fournit un signal de commande pour alimenter le circuit pour le premier et/ou le deuxième actionneur.

12. Le simulateur de route selon la revendication 11, dans lequel la commande désignée est distante d'une interface utilisateur pour faire fonctionner le simulateur de route afin d'effectuer l'essai du véhicule en commandant au moins un ensemble rotatif.

13. Le simulateur de route selon la revendication 11, dans lequel la commande désignée fait partie d'une interface utilisateur pour faire fonctionner le simulateur de route afin d'effectuer l'essai du véhicule en commandant au moins un ensemble rotatif.
